# EUROPÄISCHE PATENTANMELDUNG

(11) **EP 4 280 095 A1**
(43) Veröffentlichungstag der Anmeldung: **22.11.2023**
(21) Anmeldenummer: 22174175.4
(22) Anmeldetag: 18.05.2022
(51) Int. Cl.: G06F 30/27, G07C 9/00

(54) **VERFAHREN ZUM ERZEUGEN VON VORSCHLÄGEN, BETREFFEND EINE ODER MEHRERE ZUTRITTSKOMPONENTEN EINES ZUTRITTSSYSTEMS; COMPUTERSYSTEM; TRAININGSDATEN; COMPUTERPROGRAMMPRODUKT**

(71) Anmelder: dormakaba Schweiz AG, 8153 Rümlang (CH)
(72) Erfinder: Rappel, Christian, 8620 Wetzikon (CH); Bradfisch, Alexander, 58256 Ennepetal (DE)
(74) Vertreter: Balder IP Law, S.L.

(57) **Zusammenfassung**

Die Erfindung betrifft ein Verfahren zum Erzeugen von Vorschlägen, betreffend eine oder mehrere Zutrittskomponenten eines Zutrittssystems, mithilfe eines ML-Systems,
wobei das Verfahren zum Erzeugen von Vorschlägen umfasst:
--- a1) Erhalten von Plan-Daten einer Immobilie durch das ML-System, wobei die Plan-Daten die Planungsphase der Immobile und/oder eines Zutrittssystems der Immobilie betreffen,
--- a2) Analysieren der Plan-Daten mithilfe des ML-Systems zum Erzeugen von mindestens einem Vorschlag, betreffend eine oder mehrere Zutrittskomponenten des Zutrittssystems der Immobilie.

## Beschreibung

Die vorliegende Erfindung betrifft ein Verfahren zum Erzeugen von Vorschlägen, betreffend eine oder mehrere Zutrittskomponenten eines Zutrittssystems. Ferner betrifft die Erfindung ein Verfahren zum Trainieren eines ML (machine learning)-Systems, sowie ein Computersystem, Trainingsdaten und ein Computerprogrammprodukt.

Zutrittssysteme, insbesondere Türsysteme, werden in oder an Gebäuden oder Arealen verwendet, um den Zutritt zu bestimmten Bereichen und Räumen zu steuern oder zu beschränken und einzelne Bereiche und Räume vom übrigen Gebäude oder Areal abzugrenzen. Zutrittskomponenten können als Teile solcher Zutrittssysteme vielseitige Funktionen übernehmen, die häufig einer elektrischen Steuerung bedürfen, beispielsweise automatische Öffnungs- oder Schließfunktionen, Sicherheitsfunktionen, Alarmfunktionen und Schlossfunktionen. Ferner bestehen für die einzelnen Komponenten von Zutrittssystemen auch mechanische Wechselwirkungen und die Komponenten sind bezüglich ihrer Größe und Ausdehnung aufeinander abgestimmt.

Bei Neubauten werden Pläne bzw. Datensätze erstellt, die die Position eines Zutrittssystem in der Immobilie und die Kombination an zu verbauenden Zutrittskomponenten, die gemeinsam das Zutrittssystem bilden sollen, angeben. Hierbei kann es jedoch vorkommen, dass Kombinationen von Zutrittskomponenten geplant werden, die nicht optimal aufeinander abgestimmt sind oder bei denen Probleme durch die spezifische gewählte Kombination von Zutrittskomponenten auftreten können. Beispielsweise kann es sein, dass ein bestimmter Antriebsmotor für einen Türflügel mit einem bestimmten Türflügeltyp kombiniert ist, die nicht optimal zueinander passen, was zu einer erhöhten Fehleranfälligkeit oder einem erhöhten Wartungsbedarf führen kann. Solche Probleme sind auch für geschultes Fachpersonal häufig nicht unmittelbar ersichtlich, sodass derartige Probleme in der Planungsphase von Immobilien oder Zutrittssystemen für Immobilien unbemerkt entstehen können.

Vor diesem Hintergrund stellt sich die Aufgabe, ein vorteilhaftes Verfahren zum Bereitstellen von Vorschlägen, betreffend eine oder mehrere Zutrittskomponenten eines Zutrittssystems, bereitzustellen, mit dem vorzugsweise eine Fehleranfälligkeit, ein Wartungsaufwand oder Kosten reduziert werden können.

Die Aufgabe wird erfindungsgemäß gelöst durch ein Verfahren zum Erzeugen von Vorschlägen, betreffend eine oder mehrere Zutrittskomponenten eines Zutrittssystems, mithilfe eines ML-Systems (Machine learning-System), wobei das Verfahren zum Erzeugen von Vorschlägen umfasst:
--- a1) Erhalten von Plan-Daten einer Immobilie durch das ML-System, wobei die Plan-Daten die Planungsphase der Immobile und/oder eines Zutrittssystems der Immobilie betreffen,
--- a2) Analysieren der Plan-Daten mithilfe des ML-Systems zum Erzeugen von mindestens einem Vorschlag, betreffend eine oder mehrere Zutrittskomponenten des Zutrittssystems der Immobilie.

Erfindungsgemäß kann somit eine vorteilhafte Analyse von Plan-Daten erfolgen, um einen vorteilhaften Vorschlag bezüglich einer Kombination von Zutrittskomponenten, die gemeinsam ein Zutrittssystem bilden sollen, zu erhalten. Das Analysieren und Erzeugen des Vorschlags wird dabei in vorteilhafter Weise durch ein ML-System durchgeführt, das vorzugsweise zur Erkennung von möglichen Problemen oder Fehlern, die für bestimmte Kombinationen von Zutrittskomponenten auftreten können, konfiguriert ist.

Das erfindungsgemäße Verfahren zum Erzeugen von Vorschlägen kann auch als Verfahren zum Bereitstellen von Vorschlägen verstanden werden.

Das ML-System ist somit in vorteilhafte derart konfiguriert, dass es Vorschläge bereitgestellt, die eine Optimierung des Zutrittssystems ermöglichen. Hierdurch kann eine besonders vorteilhafte und effektive Planung von Zutrittssystemen für Immobilien erreicht werden.

Das ML-System hat vorzugsweise Zugriff auf einen Datensatz, aufweisend Spezifikationen und/oder Informationen zu einer Vielzahl von Zutrittskomponenten, und kann auf Grundlage dieses Datensatzes in Schritt a2) Vorschläge erzeugen.

Die Plan-Daten können dem ML-System in Schritt a1) beispielsweise durch eine Person und/oder ein Computerprogramm bereitgestellt werden. Die Plan-Daten betreffen eine Immobilie, insbesondere ein Gebäude und/oder Areal. Die Plan-Daten umfassen insbesondere einen Gebäude- und/oder Areal-Plan. Die Plan-Daten können beispielsweise einen Plan, aufweisend Informationen der technischen Gebäudeausrüstung (TGA) des Gebäudes und/oder Areals, und/oder einen Schließplan umfassen. Die Plan-Daten sind insbesondere computerimplementierte Daten. Es ist denkbar, dass die Plan-Daten mithilfe einer Datenbank ausgebildet sind. Es ist denkbar, dass die Plan-Daten als digitaler Datensatz verstanden werden können, der Informationen zu dem Gebäude und/oder Areal umfasst. Es ist denkbar, dass die Plan-Daten in Form von Tabellen oder Registern hinterlegt sind. Es ist denkbar, dass die Plan-Daten Strichzeichnungen, Simulationsdarstellungen und/oder Grafiken von der Immobilie und/oder dem Zutrittssystem und/oder von Zutrittskomponenten des Zutrittssystems aufweisen. Es ist denkbar, dass die Plan-Daten mithilfe eines Computerprogramms, beispielsweise automatisiert oder durch einen Nutzer, erzeugt wurden. Es ist denkbar, dass die Plan-Daten Informationen zu der Immobilie und/oder dem Zutrittssystem und/oder zu Zutrittskomponenten des Zutrittssystems in Textform oder als Listen aufweisen. Erfindungsgemäß kommen eine Vielzahl unterschiedlicher Arten und Formate für die Plan-Daten infrage.

Beispielsweise ist es gemäß einer ersten Ausführungsvariante der vorliegenden Erfindung denkbar, dass die Vorschläge, die gemäß Schritt a2) durch das ML-System erzeugt werden, den Austausch einzelner Zutrittskomponenten eines Zutrittssystems oder eine Anpassung von Betriebsparametern von einzelnen Zutrittskomponenten eines Zutrittssystems betreffen, wodurch eine Lebenszeitverlängerung des Zutrittssystems oder eine Verringerung des Wartungsaufwands ermöglicht wird. In diesem Fall ist es denkbar, dass die in Schritt a1) von dem ML-System erhaltenen Plan-Daten bereits Informationen zu einem geplanten Zutrittssystem der Immobilie enthalten, wobei die Plan-Daten insbesondere eine geplante Kombination von Zutrittskomponenten angeben, die das geplante Zutrittssystem bilden sollen. Bei Neubauten werden typischerweise in der Planungsphase Kombinationen von Zutrittskomponenten ausgewählt, die gemeinsam als Zutrittssystem in einer Immobilie verbaut werden sollen. Hierfür kommen beispielsweise Computerprogramme infrage, in denen ein Architekt oder Planer, die einzelnen Zutrittskomponenten auswählen kann und so Plan-Daten, aufweisend Informationen zu der gewählten Kombination von Zutrittskomponenten erzeugt. Es ist beispielsweise denkbar, dass solche Plan-Daten per "Drag-and-Drop" durch Auswählen der einzelnen Zutrittskomponenten mithilfe eines Computerprogramms erstellt werden. Das ML-System ist in Schritt a) vorzugsweise dazu konfiguriert, diese in den Plan-Daten enthaltene geplante Kombination von Zutrittskomponenten zu analysieren und zu prüfen und einen Veränderungsvorschlag auszugeben, wenn das ML-System Optimierungsmöglichkeiten erkennt.

Beispielsweise ist es gemäß einer zweiten Ausführungsvariante der vorliegenden Erfindung denkbar, dass das ML-System eigenständig Kombinationen von Zutrittskomponenten, beispielsweise in Abhängigkeit von in den Plan-Daten vorhandenen architektonischen Daten, ermittelt oder zusammenstellt und somit eigenständige Vorschläge für ein verbaubares Zutrittssystem erzeugt. In diesem Fall ist es denkbar, dass die Plan-Daten noch keine Informationen zu einem geplanten Zutrittssystem bzw. keine Auswahl an Zutrittskomponenten enthalten, sondern dass das ML-System völlig eigenständig einen Vorschlag, also einen Neuvorschlag, erzeugt.

Die erste und die zweite Ausführungsvariante können auch kombiniert werden, sodass das ML-System sowohl zur Erzeugung von Veränderungsvorschlägen als auch zur Erzeugung von Neuvorschlägen konfiguriert ist.

Das erfindungsgemäße Verfahren ist insbesondere ein computerimplementiertes Verfahren, bei dem ein, mehrere oder alle Schritte des Verfahrens computerimplementiert ausgeführt werden.

Das Zutrittssystem ist insbesondere für den Einbau in einer Immobilie, vorzugsweise in einem Gebäude und/oder Areal, vorgesehen. Gemäß einer Ausführungsform der vorliegenden Erfindung kann unter einem Zutrittssystem ein Vereinzelungs- und/oder Türsystem verstanden werden. Gemäß einer Ausführungsform der vorliegenden Erfindung kann unter einer Zutrittskomponente insbesondere ein Subsystem eines Zutrittssystems verstanden werden. Es ist gemäß einer Ausführungsform der vorliegenden Erfindung denkbar, dass ein Zutrittssystem eine Kombination aus einer, mehreren oder allen der folgenden Zutrittskomponenten umfasst:
- ein Türelement und/oder ein Vereinzelungselement,
- ein Scharnier,
- ein Brandschutzelement,
- ein Schloss, insbesondere ein elektrisches Schloss,
- eine Öffnungs- und/oder Schließvorrichtung für ein Türelement, insbesondere umfassend einen Aktuator und/oder Motor,
- eine Personenkontroll- und/oder Identitätskontrolleinrichtung, insbesondere ein Lesegerät für einen Pass,
- eine Zutrittskontrolleinrichtung, insbesondere eine Code- oder Passwortkontrolle,
- einen biometrischen Sensor,
- einen optischen Sensor,
- einen akustischen Sensor,
- eine elektrische Strom- und/oder Spannungsversorgung,
- eine Anzeigeeinrichtung,
- ein Leuchtmittel,
- eine akustische Ausgabevorrichtung,
- eine Warn- und/oder Sicherheitsvorrichtung,
- eine Eingabevorrichtung und/oder ein Betätigungselement, beispielsweise ein Druckknopf oder ein Touchpad,
- eine Steuerungsvorrichtung. Es ist denkbar, dass die Steuerungsvorrichtung zur Ansteuerung von Zutrittskomponenten des Zutrittssystems und/oder zur Konfiguration von Zutrittskomponenten des Zutrittssystems ausgebildet ist.

Gemäß einer Ausführungsform der vorliegenden Erfindung ist es denkbar, dass das Zutrittssystem eines der folgenden Türsysteme und/oder Vereinzelungssysteme ist:
- eine Drehtür,
- eine Drehflügeltür,
- eine Karusselltür,
- eine Sicherheitskarusselltür,
- eine Personenschleuse,
- eine Schiebetür,
- eine Faltschiebetür,
- eine Drehsperre,
- ein Drehkreuz,
- eine Schwenktür.

Das ML-System kann gemäß einer Ausführungsform der vorliegenden Erfindung auch als KI (künstliche Intelligenz)-System verstanden werden. Es ist denkbar, dass das ML-System als Deep-Learning-System ausgebildet ist. Es kann beispielsweise mithilfe eines neuronalen Netzes gebildet sein.

Vorteilhafte Weiterbildungen und Ausgestaltungen der vorliegenden Erfindung können den abhängigen Ansprüchen entnommen werden.

Gemäß einer Ausführungsform der vorliegenden Erfindung ist es denkbar, dass das Verfahren ferner umfasst:
--- a3) Ausgeben des mindestens einen in Schritt a2) erzeugten Vorschlags, insbesondere in Abhängigkeit der in Schritt a2) durchgeführten Analyse. Der Vorschlag kann somit einem Nutzer bereitgestellt werden. Das Ausgeben des Vorschlags kann beispielsweise innerhalb einer Computersoftware für Gebäudeplanungen erfolgen, wobei der Vorschlag einem Nutzer durch die Computersoftware angezeigt wird, beispielsweise auf einem Computerbildschirm. Gemäß einer Ausführungsform der vorliegenden Erfindung ist es denkbar, dass alternativ oder zusätzlich zu Schritt a3)
--- ein Ergänzen und/oder Ändern der Plan-Daten durch den Vorschlag, betreffend die eine oder die mehreren Zutrittskomponenten des Zutrittssystems, in Abhängigkeit der in Schritt a2) durchgeführten Analyse erfolgt. Es ist denkbar, dass die Plan-Daten durch den mindestens einen Vorschlag automatisiert ergänzt und/oder geändert werden.

Gemäß einer Ausführungsform der vorliegenden Erfindung ist es vorgesehen, dass die in Schritt a1) durch das ML-System erhaltenen Plan-Daten Informationen zu dem Zutrittssystem aufweisen, wobei das Zutrittssystem eine Kombination von Zutrittskomponenten aufweist,
wobei der in Schritt a2) erzeugte Vorschlag ein Veränderungsvorschlag, betreffend eine oder mehrere der Zutrittskomponenten des Zutrittssystems, ist. In diesem Fall ist es denkbar, dass die Plan-Daten bereits Informationen zu einer Kombination von Zutrittskomponenten aufweisen die gemeinsam als Teil des geplanten Zutrittssystems verwendet werden soll, vorzugsweise wobei diese Informationen vor Schritt a1) durch einen Nutzer, beispielsweise einen Architekten oder Fachplaner, unter Verwendung eines Computerprogramms erzeugt wurden. Das ML-System analysiert in Schritt a2) vorzugsweise die Informationen zu dem Zutrittssystem, und erzeugt einen Veränderungsvorschlag bezüglich einer oder mehrerer der Zutrittskomponenten des Zutrittssystems.

Gemäß einer Ausführungsform der vorliegenden Erfindung ist es vorgesehen, dass der Veränderungsvorschlag einen oder mehrere der folgenden Veränderungsvorschläge betrifft:
- einen Austausch von einer oder mehreren Zutrittskomponenten des Zutrittssystems;
- ein Anpassen eines Prüfungsintervalls und/oder Wartungsintervalls des Zutrittssystems und/oder von einer oder mehreren Zutrittskomponenten des Zutrittssystems;
- ein Einstellen und/oder Anpassen von mechanischen, hydraulischen und/oder elektrischen Parametern des Zutrittssystems und/oder von einer oder mehreren Zutrittskomponenten des Zutrittssystems. Der Veränderungsvorschlag kann somit insbesondere ein Vorschlag zum Austausch einer im geplanten Zutrittssystem vorhandenen Zutrittskomponente durch eine andere Zutrittskomponente sein. Beispielsweise könnte das ML-System in Abhängigkeit seiner Analyse in Schritt a2) vorschlagen, ein im Zutrittssystem geplantes Scharnier durch einen anderen Scharniertyp auszutauschen, um die erwartete Lebenszeit eines Motors des Zutrittssystems zu verlängern. Das ML-System ist insbesondere zur Identifizierung derartiger Abhängigkeiten zwischen den einzelnen Zutrittskomponenten eines Zutrittssystems trainiert und gibt entsprechende Veränderungsvorschläge aus. Das Einstellen und/oder Anpassen eines mechanischen Parameters des Zutrittssystems und/oder von einer oder mehreren Zutrittskomponenten des Zutrittssystems kann beispielsweise mechanische Anpassungen am Türscharnier, ein Nachstellen von Schrauben oder Ähnliches umfassen. Die Abwandlung/Änderung von einzelnen Zutrittskomponenten könnte beispielsweise eine Veränderung des Türschließers betreffen. Es sind generell eine Vielzahl unterschiedlicher Veränderungen und Anpassungen denkbar, wobei das ML-System derart konfiguriert ist, dass es vorteilhafte Änderungen identifiziert und vorschlägt.

Gemäß einer Ausführungsform der vorliegenden Erfindung ist es vorgesehen, dass das Verfahren ferner umfasst:
--- a0) Erzeugen, Ergänzen und/oder Ändern zumindest eines Teils der Plan-Daten mithilfe eines Planungsprogramms, wobei zumindest die Kombination von Zutrittskomponenten des Zutrittssystems ausgewählt und/oder erzeugt wird, insbesondere durch einen Nutzer des Planungsprogramms. Schritt a0) findet insbesondere vor Schritt a1) statt. Die mithilfe des Planungsprogramms ausgewählte und/oder erzeugte Kombination von Zutrittskomponenten des Zutrittssystem ist somit Teil der Plan-Daten, die in Schritt a1) von dem ML-System erhalten werden. Das Planungsprogramm ist vorzugsweise ein Computerprogramm, das zur Planung von Immobilien und/oder zur Planung von Zutrittssystemen für Immobilien verwendet wird.

Gemäß einer Ausführungsform der vorliegenden Erfindung ist es vorgesehen, dass die in Schritt a1) durch das ML-System erhaltenen Plan-Daten eine, mehrere oder alle der folgenden Informationen aufweisen:
- architektonische Informationen, insbesondere bezüglich eines vorhandenen Bauraums für das Zutrittssystem oder für Zutrittskomponenten des Zutrittssystems; und/oder
- Sicherheitsanforderungsinformationen, betreffend Sicherheitsanforderungen an das Zutrittssystem oder an Zutrittskomponenten des Zutrittssystems; und/oder
- Benutzungsfrequenzinformationen, betreffend eine erwartete Benutzungsfrequenz des Zutrittssystems oder von Zutrittskomponenten des Zutrittssystems.

Gemäß einer Ausführungsform der vorliegenden Erfindung ist es vorgesehen, dass das ML-System in Schritt a2) den mindestens einen Veränderungsvorschlag unter Berücksichtigung:
- der architektonischen Informationen; und/oder
- der Sicherheitsanforderungsinformationen; und/oder
- der Benutzungsfrequenzinformationen
erzeugt. Somit kann das ML-System bei der Erzeugung des Vorschlags, insbesondere des Veränderungsvorschlags oder des Neuvorschlags, in vorteilhafter Weise die Anforderungen an das Zutrittssystem und die lokalen Bedingungen und Gegebenheiten berücksichtigen.

Gemäß einer Ausführungsform der vorliegenden Erfindung ist es vorgesehen, dass der Vorschlag in Schritt a2) ein durch das ML-System erzeugter Neuvorschlag einer Kombination von Zutrittskomponenten für ein Zutrittssystem ist, wobei der Neuvorschlag durch das ML-System zumindest in Abhängigkeit der in den Plan-Daten vorhandenen architektonischen Informationen, Sicherheitsanforderungsinformationen und/oder Benutzungsfrequenzinformationen erzeugt wird. Die Plan-Daten, die das ML-System in Schritt a1) erhält, müssen in diesem Fall keinen Vorschlag für ein geplantes Zutrittssystem bzw. eine geplante Kombination von Zutrittskomponenten enthalten. Das ML-System kann hingegen in Schritt a2) automatisiert einen eigenständigen Neuvorschlag für eine Kombination von Zutrittskomponenten zur Bildung eines Zutrittssystems erzeugen. Diesen Neuvorschlag erarbeitet das ML-System auf der Grundlage der Plan-Daten, wobei vorzugsweise der vorhandene Bauraum, insbesondere Maße und bauliche Planungen der Immobilie, berücksichtigt werden.

Gemäß einer Ausführungsform der vorliegenden Erfindung ist es vorgesehen, dass das ML-System in Schritt a2) den mindestens einen Vorschlag, insbesondere den Veränderungsvorschlag oder Neuvorschlag, unter Berücksichtigung eines, mehrerer oder aller der folgenden Eigenschaften und/oder Parameter erzeugt:
- eine von dem ML-System erwartete Abnutzung des Zutrittssystems oder einer oder mehrerer Zutrittskomponenten des Zutrittssystems; und/oder
- ein von dem ML-System erwarteter Wartungsaufwands des Zutrittssystems oder einer oder mehrerer Zutrittskomponenten des Zutrittssystems; und/oder
- eine von dem ML-System erwartete Lebensdauer des Zutrittssystems oder einer oder mehrerer Zutrittskomponenten des Zutrittssystems; und/oder
- eine von dem ML-System erwartete Fehleranfälligkeit des Zutrittssystems oder einer oder mehrerer Zutrittskomponenten des Zutrittssystems; und/oder
- ein von dem ML-System erwarteter elektrischer Energiebedarf des Zutrittssystems oder einer oder mehrerer Zutrittskomponenten des Zutrittssystems,
vorzugsweise jeweils bezüglich einer bestimmten Kombination von Zutrittskomponenten. Das ML-System nimmt somit vorzugsweise eine Optimierung bezüglich der erwarteten Abnutzung, der erwarteten Lebensdauer, der erwarteten Fehleranfälligkeit, des erwarteten Wartungsaufwands und/oder des erwarteten elektrischen Energiebedarfs oder Leistungsbedarfs vor.

Gemäß einer Ausführungsform der vorliegenden Erfindung ist es vorgesehen, dass das Analysieren in Schritt a2) umfasst:
--- Vorhersagen von Problemen, betreffend eine in den Plan-Daten vorhandene Kombination von Zutrittskomponenten des mindestens einen Zutrittssystems, durch das ML-System, vorzugsweise wobei die vorhergesagten Probleme eines, mehrere oder alle der folgenden Probleme betreffen:
- eine durch das ML-System vorhergesagte erhöhte Abnutzung des Zutrittssystems oder von einer oder mehreren der Zutrittskomponenten des Zutrittssystems; und/oder
- eine durch das ML-System vorhergesagte erhöhte Fehleranfälligkeit des Zutrittssystems oder von einer oder mehreren der Zutrittskomponenten des Zutrittssystems; und/oder
- ein durch das ML-System vorhergesagter erhöhter Wartungsaufwand des Zutrittssystems oder von einer oder mehreren der Zutrittskomponenten des Zutrittssystems; und/oder
- eine durch das ML-System vorhergesagte verringerte Lebenszeit des Zutrittssystems oder von einer oder mehreren der Zutrittskomponenten des Zutrittssystems; und/oder
- ein durch das ML-System vorhergesagter erhöhter elektrischer Energiebedarf des Zutrittssystems oder von einer oder mehreren der Zutrittskomponenten des Zutrittssystems. Die vorhergesagten Probleme betreffen dabei vorzugsweise die spezifische Kombination von Zutrittskomponenten des geplanten Zutrittssystems, die in den Plan-Daten vorhanden ist. Es ist in vorteilhafter Weise denkbar, dass das ML-System in Schritt a2) den mindestens einen Veränderungsvorschlag in Abhängigkeit der vorhergesagten Probleme der Kombination von Zutrittskomponenten des Zutrittssystems erzeugt. Das ML-System ist vorzugsweise zur Berücksichtigung der vorgenannten Probleme beim Analysieren der Plan-Daten und beim Erzeugen des Veränderungsvorschlags trainiert. Insbesondere ist es somit denkbar, dass das ML-System bei der Erzeugung des Veränderungsvorschlags:
   - eine durch das ML-System vorhergesagte Veränderung der Abnutzung des Zutrittssystems oder einer oder mehrerer Zutrittskomponenten des Zutrittssystems; und/oder
   - eine durch das ML-System vorhergesagte Veränderung des Wartungsaufwands des Zutrittssystems oder einer oder mehrerer Zutrittskomponenten des Zutrittssystems; und/oder
   - eine durch das ML-System vorhergesagte Veränderung der Lebensdauer des Zutrittssystems oder einer oder mehrerer Zutrittskomponenten des Zutrittssystems; und/oder
   - eine durch das ML-System vorhergesagte Veränderung der Fehleranfälligkeit des Zutrittssystems oder einer oder mehrerer Zutrittskomponenten des Zutrittssystems; und/oder
   - eine durch das ML-System vorhergesagte Veränderung des elektrischen Energiebedarfs des Zutrittssystems oder einer oder mehrerer Zutrittskomponenten des Zutrittssystems
berücksichtigt,
die durch den Veränderungsvorschlag erreicht werden.

Gemäß einer Ausführungsform der vorliegenden Erfindung ist es vorgesehen, dass das ML-System in Schritt a2) den mindestens einen Vorschlag, insbesondere den Veränderungsvorschlag oder Neuvorschlag, unter Berücksichtigung einer erwarteten Lieferzeit von Zutrittskomponenten und/oder einer Verfügbarkeit von Zutrittskomponenten erzeugt. Hierdurch kann das ML-System eine aktuelle Verfügbarkeit und/oder typische Lieferzeit von bestimmten Zutrittskomponenten, die das ML-System als Teil des Vorschlags vorschlägt, berücksichtigen. Das ML-System kann somit beispielsweise verhindern, dass es Vorschläge ausgibt, die zu einer unnötigen oder langen Verzögerung von Baumaßnahmen führen würden. Es ist alternativ oder zusätzlich denkbar, dass das ML-System erwartete Kosten bei der Erzeugung des Vorschlags berücksichtigt, insbesondere Kosten, die durch den Einbau oder die Einstellung von Parametern von bestimmten Zutrittskomponenten entstehen.

Gemäß einer Ausführungsform der vorliegenden Erfindung ist es vorgesehen, dass das ML-System in Schritt a2) den mindestens einen Vorschlag zur Angleichung und/oder Abstimmung der erwarteten Wartungsintervalle der einzelnen Türkomponenten des Türsystems erzeugt. Da sich die Immobilie oder das Zutrittssystem noch in der Planungsphase befindet, kann das ML-System bei der Erzeugung seines Vorschlags eine Optimierung dahingehend vornehmen, dass die Zutrittskomponenten des geplanten Zutrittssystems aufeinander abgestimmte Wartungsintervalle aufweisen, beispielsweise jeweils das gleiche Wartungsintervall oder jeweils ähnliche Wartungsintervalle. Somit können der spätere Aufwand und die Kosten geringgehalten werden. Das ML-System kann dabei eine gesamtheitliche Betrachtung der Zutrittskomponenten des geplanten Zutrittssystems vornehmen.

Ein weiterer Gegenstand der vorliegenden Erfindung ist ein Verfahren zum Trainieren eines ML-Systems, insbesondere zur Verwendung des trainierten ML-Systems in einem Verfahren zum Erzeugen von Vorschlägen gemäß einer Ausführungsform der vorliegenden Erfindung,
wobei das Verfahren zum Trainieren des ML-Systems die folgenden Schritte umfasst:
--- b1) Ermitteln und/oder Bereitstellen von Trainingsdaten zum Trainieren des ML-Systems,
--- b2) Trainieren des ML-Systems mithilfe der Trainingsdaten zum Erzeugen von Vorschlägen, betreffend eine oder mehrere Zutrittskomponenten eines Zutrittssystems. Das erfindungsgemäß trainierte ML-System ist insbesondere in den Schritten a1), a2) und optional a3) verwendbar. Das ML-System wird insbesondere zur Erzeugung von Vorschlägen, betreffend eine oder mehrere Zutrittskomponenten eines Zutrittssystems einer Immobilie, in der Planungsphase der Immobilie oder des Zutrittssystems trainiert.

Gemäß einer Ausführungsform der vorliegenden Erfindung ist es vorgesehen, dass die Trainingsdaten:
- Kombinationen von Zutrittskomponenten von Zutrittssystemen und
- in der Anwendung der Kombinationen von Zutrittskomponenten ermittelte Fehler, Abnutzungserscheinungen, Probleme und/oder Eigenschaften betreffen. Die Trainingsdaten stammen vorzugsweise aus der Wartung und/oder Kontrolle und/oder Prüfung realer, in der Anwendung verwendeter Zutrittssysteme. Es existiert in der Praxis eine große Vielzahl an verbauten Zutrittssystemen, die gewartet werden und/oder an denen Reparaturen vorgenommen werden. Durch ein Nachhalten der in der Praxis auftretenden Fehler und Probleme, die im Zuge solcher Wartungsarbeiten oder Reparaturarbeiten identifiziert werden, und ein Verknüpfen der aufgetreten Fehler und Probleme mit Informationen zu den jeweils in Kombination verwendeten Zutrittskomponenten der Zutrittssysteme, an denen die Fehler und Probleme aufgetreten sind, kann eine äußerst umfangreiche Datenbasis erzeugt werden, die zum Trainieren des ML-Systems verwendet werden kann. Es kann daher mit geringem Aufwand ein umfangreicher Trainingsdatensatz erzeugt werden, in dem Informationen zu den Fehlern, Abnutzungserscheinungen, Problemen und/oder Eigenschaften enthalten sind, die in der Wartung und/oder Kontrolle und/oder Prüfung realer Zutrittssysteme ermittelt wurden. Das ML-System kann anhand eines solchen Trainingsdatensatzes dazu trainiert werden, Problem zu ermitteln, die durch die Verwendung bestimmter Kombinationen von Zutrittskomponenten auftreten, und die beispielsweise durch Fachpersonal nicht unbedingt eigenständig identifizierbar wären. Das trainierte ML-System kann solche potentiellen Probleme in Plan-Daten, die Informationen zu bestimmten Kombinationen von Zutrittssystemen aufweisen, identifizieren und Änderungen vorschlagen, um die potentiellen Probleme zu verringern. Alternativ oder zusätzlich kann das ML-System Neuvorschläge für geplante Zutrittssysteme ausgeben, die solche Probleme vermeiden.

Gemäß einer Ausführungsform der vorliegenden Erfindung ist es denkbar, dass die Trainingsdaten
- Informationen zu den Maßen und/oder dem benötigten Bauraum von Zutrittskomponenten und/oder Zutrittssystemen; und/oder
- Informationen zu den Sicherheitsanforderungen, die Zutrittskomponenten und/oder Zutrittssysteme erfüllen; und/oder
- Informationen zu Benutzungsfrequenzen, für die die Zutrittskomponenten und/oder Zutrittssysteme ausgelegt sind,
   enthalten.

Gemäß einer Ausführungsform der vorliegenden Erfindung ist es vorgesehen, dass das ML-System in Schritt b2) zur Erkennung und/oder Vorhersage von Problemen, betreffend Kombinationen von Zutrittskomponenten von Zutrittssystemen, trainiert wird.

Das erfindungsgemäß Verfahren umfasst somit vorzugsweise ein Verfahren zum Trainieren eines ML-Systems zur Erkennung und/oder Vorhersage von Problemen, betreffend Kombinationen von Zutrittskomponenten von Zutrittssystemen. Die Probleme, betreffend Kombinationen von Zutrittskomponenten von Zutrittssystemen, können insbesondere eines, mehrere oder alle der folgenden Probleme sein:
- eine erhöhte Abnutzung des Zutrittssystems oder von einer oder mehreren der Zutrittskomponenten des Zutrittssystems; und/oder
- eine erhöhte Fehleranfälligkeit des Zutrittssystems oder von einer oder mehreren der Zutrittskomponenten des Zutrittssystems; und/oder
- ein erhöhter Wartungsaufwand des Zutrittssystems oder von einer oder mehreren der Zutrittskomponenten des Zutrittssystems; und/oder
- eine verringerte Lebenszeit des Zutrittssystems oder von einer oder mehreren der Zutrittskomponenten des Zutrittssystems; und/oder
- ein erhöhter elektrischer Energiebedarf des Zutrittssystems oder von einer oder mehreren der Zutrittskomponenten des Zutrittssystems. Derartige Probleme sind insbesondere durch die jeweils verwendete Kombination von Zutrittskomponenten des Zutrittssystems bedingt.

Gemäß einer Ausführungsform der vorliegenden Erfindung ist es vorgesehen,
- dass das ML-System in Schritt b2) zum Erzeugen von Veränderungsvorschlägen, betreffend eine oder mehrere Zutrittskomponenten eines Zutrittssystems, in Abhängigkeit von erkannten und/oder vorhergesagten Problemen für Kombinationen von Zutrittskomponenten trainiert wird; und/oder
- dass das ML-System in Schritt b2) zum Erzeugen von Neuvorschlägen, betreffend Kombinationen von Zutrittskomponenten für ein Zutrittssystem, in Abhängigkeit von vorhergesagten Problemen für Kombinationen von Zutrittskomponenten trainiert wird.

Gemäß einer Ausführungsform der vorliegenden Erfindung ist es vorgesehen, dass die Trainingsdaten:
- Zutrittskomponenteninformationen, betreffend die in Kombination verwendeten Zutrittskomponenten von Zutrittssystemen; und
- Labelinformationen, betreffend in der Anwendung der in Kombination verwendeten Zutrittskomponenten ermittelte Fehler, Probleme, Abnutzungserscheinungen, und/oder Eigenschaften
   umfassen,
wobei in Schritt b2) mithilfe der Zutrittskomponenteninformationen und Labelinformationen ein überwachtes Lernen zum Training des ML-Systems durchgeführt wird. Es kann somit ein vorteilhaftes überwachtes Lernen mithilfe von Labeln bzw. Labelinformationen erfolgen, die die in der Anwendung ermittelten Fehler, Probleme, Abnutzungserscheinungen, und/oder
Eigenschaften von in Kombination verwendeten Zutrittskomponenten aufweisen. Diese Labelinformationen können auf Erfahrungswerten beruhen, die sich in der Wartung und der Reparatur einer Vielzahl von Zutrittssystemen ergeben haben. Auch Methoden des bestärkenden Lernens oder unüberwachten Lernens sind zum Training des ML-Systems denkbar.

Ein weiterer Gegenstand der vorliegenden Erfindung ist ein Computersystem, aufweisend ein ML-System, wobei das Computersystem zum Ausführen eines Verfahrens gemäß einer Ausführungsform der vorliegenden Erfindung konfiguriert ist. Insbesondere umfasst das Computersystem Computermittel, die zur Ausführung eines Verfahrens gemäß einer Ausführungsform der vorliegenden Erfindung konfiguriert sind. Gemäß einer Ausführungsform der vorliegenden Erfindung ist das Computersystem zumindest zur Ausführung der Schritte a1) und a2) konfiguriert, wobei das Computersystem optional zur Ausführung des Schritts a3) und/oder des Schritts a0) konfiguriert ist.

Ein weiterer Gegenstand der vorliegenden Erfindung sind Trainingsdaten zur Verwendung in einem Verfahren zum Trainieren eines ML-Systems gemäß einer Ausführungsform der vorliegenden Erfindung,
wobei die Trainingsdaten:
- Kombinationen von Zutrittskomponenten von Zutrittssystemen und
- in der Anwendung der Kombinationen von Zutrittskomponenten ermittelte Fehler, Abnutzungserscheinungen, Probleme und/oder Eigenschaften betreffen. Die Trainingsdaten sind somit zum Trainieren eines ML-Systems zum Bereitstellen von Vorschlägen, betreffend eine oder mehrere Zutrittskomponenten eines Zutrittssystems, vorgesehen und/oder konfiguriert. Die Trainingsdaten stammen vorzugsweise aus der Wartung und Reparatur in der Anwendung befindlicher Zutrittssysteme.

Ein weiterer Gegenstand der vorliegenden Erfindung ist ein Computerprogrammprodukt, umfassend Befehle, die bei der Ausführung durch ein Computersystem, dieses veranlassen, ein Verfahren gemäß einer Ausführungsform der vorliegenden Erfindung durchzuführen.

Die Merkmale, Ausführungsformen und Vorteile, die im Zusammenhang mit einem der erfindungsgemäßen Gegenstände beschrieben worden sind, können jeweils auch für die weiteren erfindungsgemäßen Gegenstände Anwendung finden. Insbesondere können für das erfindungsgemäße Computersystem, die erfindungsgemäßen Trainingsdaten und das erfindungsgemäße Computerprogrammprodukt dabei die Merkmale, Ausführungsformen und Vorteile Anwendung finden, die bereits im Zusammenhang mit dem erfindungsgemäßen Verfahren zum Erzeugen von Vorschlägen oder im Zusammenhang mit einer Ausführungsform des erfindungsgemäßen Verfahrens zum Erzeugen von Vorschlägen beschrieben worden sind. Ferner können für das erfindungsgemäße Computersystem, die erfindungsgemäßen Trainingsdaten und das erfindungsgemäße Computerprogrammprodukt dabei die Merkmale, Ausführungsformen und Vorteile Anwendung finden, die bereits im Zusammenhang mit dem erfindungsgemäßen Verfahren zum Trainieren eines ML-Systems oder im Zusammenhang mit einer Ausführungsform des erfindungsgemäßen Verfahrens zum Trainieren eines ML-Systems beschrieben worden sind.

Nachfolgend sollen weitere Vorteile und Einzelheiten der Erfindung anhand der in den Zeichnungen dargestellten Ausführungsbeispiele erläutert werden. Hierin zeigen
- Fig. 1A: eine schematische Darstellung eines Zutrittssystems gemäß einem Ausführungsbeispiel der vorliegenden Erfindung;
- Fig. 1B: eine schematische Darstellung einer Immobilie gemäß einem Ausführungsbeispiel der vorliegenden Erfindung;
- Fig. 2: eine schematische Darstellung eines Computersystems gemäß einem Ausführungsbeispiel der vorliegenden Erfindung;
- Fig. 3A: eine schematische Darstellung eines Verfahrens zum Erzeugen von Vorschlägen gemäß einem Ausführungsbeispiel der vorliegenden Erfindung;
- Fig. 3B: eine schematische Darstellung eines Verfahrens zum Trainieren eines ML-Systems gemäß einem Ausführungsbeispiel der vorliegenden Erfindung;
- Fig. 4 bis 7: jeweils schematische Darstellungen von Verfahren gemäß Ausführungsbeispielen der vorliegenden Erfindung.

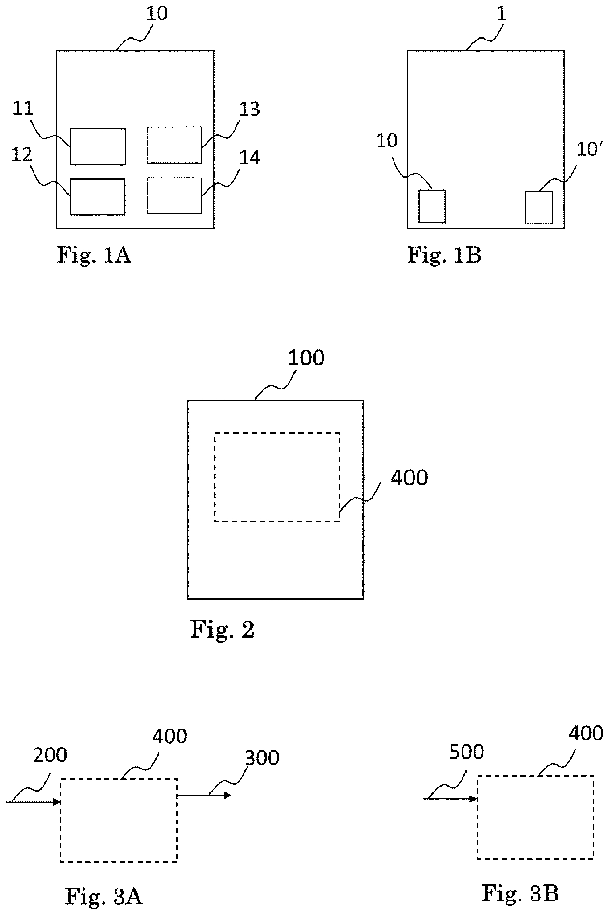

In Fig. 1A ist eine schematische Blockdarstellung eines Zutrittssystems 10 gemäß einem Ausführungsbeispiel der vorliegenden Erfindung gezeigt. Das Zutrittssystem 10 ist vorzugsweise als Türsystem oder Vereinzelungssystem ausgebildet und dafür vorgesehen, in einem Gebäude oder Areal verbaut zu werden. Die vorliegende Erfindung bezieht sich dabei insbesondere auf die Planungsphase das Zutrittssystems oder der Immobilie, in der das Zutrittssystem verbaut werden soll. In der Planungsphase wird das Zutrittssystem geplant, ist jedoch noch nicht real in einer Immobilie verbaut. Das Zutrittssystem 10 umfasst mehrere Zutrittskomponenten 11, 12, 13, 14, die auch als Untersysteme oder Bauteile des Zutrittssystems 10 verstanden werden können. Beispielsweise umfassen die Zutrittskomponenten 11, 12, 13, 14 eine oder mehrere der folgenden Komponenten:
- ein Türelement und/oder ein Vereinzelungselement,
- ein Scharnier,
- ein Brandschutzelement,
- ein Schloss, insbesondere ein elektrisches Schloss,
- eine Öffnungs- und/oder Schließvorrichtung für ein Türelement, insbesondere umfassend einen Aktuator und/oder Motor,
- eine Personenkontroll- und/oder Identitätskontrolleinrichtung, insbesondere ein Lesegerät für einen Pass,
- eine Zutrittskontrolleinrichtung, insbesondere eine Code- oder Passwortkontrolle,
- einen biometrischen Sensor,
- einen optischen Sensor,
- einen akustischen Sensor,
- eine elektrische Strom- und/oder Spannungsversorgung,
- eine Anzeigeeinrichtung,
- ein Leuchtmittel,
- eine akustische Ausgabevorrichtung,
- eine Warn- und/oder Sicherheitsvorrichtung,
- eine Eingabevorrichtung und/oder ein Betätigungselement, beispielsweise ein Druckknopf oder ein Touchpad,
- eine Steuerungsvorrichtung. Es ist denkbar, dass die Steuerungsvorrichtung als Zutrittskomponente des Zutrittssystem ausgebildet ist oder dass die Steuerungsvorrichtung extern von dem Zutrittssystem ausgebildet ist. Die Steuerungsvorrichtung ist zur Ansteuerung von einer oder mehreren der Zutrittskomponenten 11, 12, 13, 14 konfiguriert und beispielsweise über eine drahtlose und/oder drahtgebundene Verbindung zur Kommunikation mit diesen Zutrittskomponenten eingerichtet. Beispielsweise ist ein Bus-System zwischen der Steuerungsvorrichtung 12 und einzelnen Zutrittskomponenten oder zwischen der Steuerungsvorrichtung 12 und dem Zutrittssystem ausgebildet.

In Fig, 1B ist eine schematische Darstellung einer Immobilie 1, insbesondere eines Gebäudes, gezeigt, die ein Zutrittssystem 10 gemäß einer Ausführungsform der vorliegenden Erfindung aufweist. Zusätzlich zu dem Zutrittssystem 10 kann die Immobilie eine oder mehrere weitere Zutrittssysteme 10' aufweisen.

In Fig, 2 ist eine schematische Darstellung eines Computersystems 100 gemäß einer Ausführungsform der vorliegenden Erfindung gezeigt. Das Computersystem 100 stellt ein ML-System 400 bereit, mit dessen Hilfe Vorschläge 300, betreffend eine oder mehrere Zutrittskomponenten 11, 12, 13, 14 eines Zutrittssystems 10 bereitgestellt werden können. Das Computersystem 100 kann dabei eine oder mehrere physische Computereinrichtungen umfassen. Es ist denkbar, dass das Computersystem 100 mithilfe einer Cloud ausgebildet ist.

In Fig, 3A ist eine schematische Darstellung eines Verfahrens zum Erzeugen von Vorschlägen 300, betreffend eine oder mehrere Zutrittskomponenten 11, 12, 13, 14 eines Zutrittssystems 10, gemäß einer Ausführungsform der vorliegenden Erfindung gezeigt. Ein ML-System 400 erhält Plan-Daten 200 einer Immobilie 1, wobei die Plan-Daten 200 die Planungsphase der Immobilie 1 oder eines Zutrittssystems 10 der Immobilie 1 betreffen.

Es ist dabei gemäß einer ersten Ausführungsvariante der vorliegenden Erfindung denkbar, dass die Plan-Daten 200 Informationen zu mindestens einem geplanten Zutrittssystem 10 der Immobilie 1 enthalten, in denen die Zutrittskomponenten 11, 12, 13, 14 bezeichnet sind, die das Zutrittssystem 10 aufweist.

Es ist alternativ gemäß einer zweiten Ausführungsvariante der vorliegenden Erfindung denkbar, dass die Plan-Daten 200 keine Zutrittskomponenten 11, 12, 13, 14 spezifizieren, sondern beispielsweise lediglich einen Ort in der Immobilie, in der ein Zutrittssystem geplant werden soll.

Die Plan-Daten 200 werden dem ML-System 400 in digitaler Form bereitgestellt. Vorzugsweise bilden die Plan-Daten 200 einen aktuellen Zustand der Planungsphase der Immobilie 1 und/oder des Zutrittssystems 10 ab. Das ML-System 400 ist zur Analyse der Plan-Daten 200 trainiert und erzeugt einen Vorschlag 300, betreffend eine oder mehrere der Zutrittskomponenten 11, 12, 13, 14 des Zutrittssystems 10. Der Vorschlag 300 kann durch das ML-System 400 ausgegeben werden und beispielsweise einem Nutzer oder Fachplaner angezeigt oder mitgeteilt werden.

Gemäß der ersten Ausführungsvariante der vorliegenden Erfindung betrifft der Vorschlag 300 dabei einen Veränderungsvorschlag, betreffend eine oder mehrere der Zutrittskomponenten 11, 12, 13, 14 des Zutrittssystems 10, die in den Plan-Daten 200 enthalten sind.

Gemäß der zweiten Ausführungsvariante der vorliegenden Erfindung betrifft der Vorschlag 300 dabei einen durch das ML-System 400 erzeugten Neuvorschlag einer Kombination von Zutrittskomponenten 11, 12, 13, 14 für ein Zutrittssystem 10, wobei der Neuvorschlag durch das ML-System 400 zumindest in Abhängigkeit der in den Plan-Daten 200 vorhandenen architektonischen Informationen, Sicherheitsanforderungsinformationen und/oder Benutzungsfrequenzinformationen erzeugt wird. Der Neuvorschlag ist dabei vorzugsweise ein eigenständig durch das ML-System 400 erzeugter Vorschlag einer Kombination von Zutrittskomponenten 11, 12, 13, 14, die als Teil eines Zutrittssystems 10 für die Immobilie 1 verwendbar sind.

In Fig, 3B ist eine schematische Darstellung eines Verfahrens zum Trainieren eines ML-Systems 400 gemäß einer Ausführungsform der vorliegenden Erfindung gezeigt. Das ML-System 400 wird durch bereitgestellte Trainingsdaten 500 trainiert. Die Trainingsdaten 500 werden durch Messungen, Reparaturarbeiten und/oder Wartungsarbeiten an einer Vielzahl von realen Türsystemen erhalten und umfassen Informationen:
- zu den jeweils in diesen Zutrittssystemen in Kombinationen verwendeten Zutrittskomponenten 11, 12, 13, 14 und
- zu Fehlern, Abnutzungserscheinungen, Problemen und/oder Eigenschaften, die jeweils durch die Messungen, Reparaturarbeiten und/oder Wartungsarbeiten der Vielzahl von realen Türsystemen ermittelt wurden. Durch die Vielzahl an realen Türsystemen, an denen in der Praxis regelmäßig oder unregelmäßig Reparaturen und Wartungen durchgeführt werden, kann somit eine breite Datenbasis für das Training des ML-Systems 400 erzeugt werden. Das ML-System 400 wird auf diese Weise zum Erzeugen von Vorschlägen 300, betreffend eine oder mehrere Zutrittskomponenten 11, 12, 13, 14 eines Zutrittssystems 10, trainiert. Das Trainieren des ML-Systems 400 kann dabei auch kontinuierlich durchgeführt werden, sodass das ML-System 400 weiter trainiert werden kann, wenn es sich bereits in der Anwendung befindet.

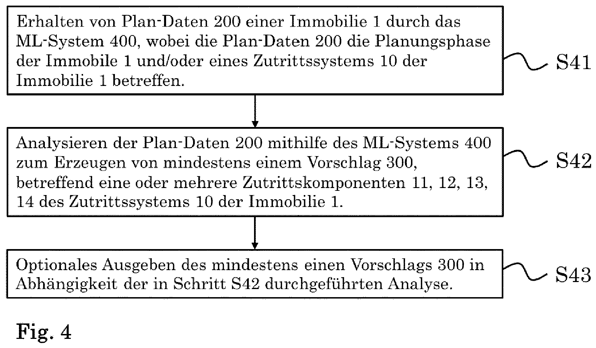

In Fig. 4 ist eine schematische Darstellung eines Verfahrens zum Erzeugen von Vorschlägen 300 gemäß einer Ausführungsform der vorliegenden Erfindung gezeigt. In einem Schritt S41 werden Plan-Daten 200 einer Immobilie 1 durch das ML-System 400 erhalten, wobei die Plan-Daten 200 die Planungsphase der Immobile 1 und/oder eines Zutrittssystems 10 der Immobilie 1 betreffen. In einem Schritt S42 erfolgt ein Analysieren der Plan-Daten 200 mithilfe des ML-Systems 400 zum Erzeugen von mindestens einem Vorschlag 300, betreffend eine oder mehrere Zutrittskomponenten 11, 12, 13, 14 des Zutrittssystems 10 der Immobilie 1. In Schritt S43 erfolgt ein optionales Ausgeben des mindestens einen Vorschlags 300 in Abhängigkeit der in Schritt S42 durchgeführten Analyse. Insbesondere wird der in Schritt S43 erzeugte mindestens eine Vorschlag 300 ausgegeben und derart einem Nutzer zur Verfügung gestellt. Das Ausgeben des Veränderungsvorschlags kann beispielsweise optisch über einen Computerbildschirm des Computersystems 100 erfolgen.

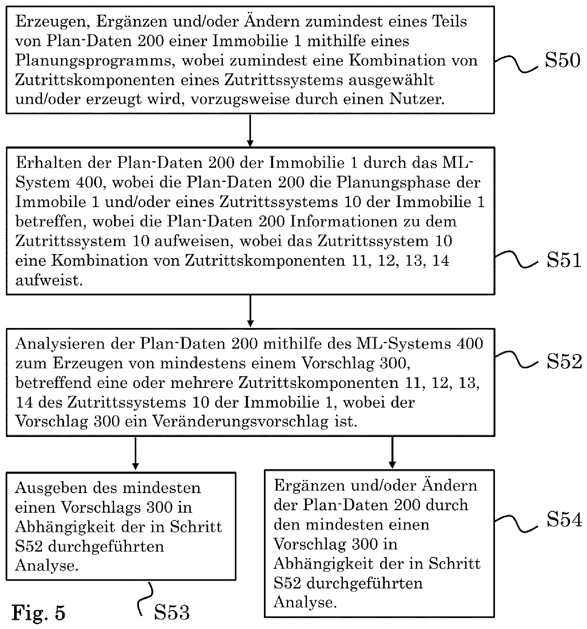

In Fig. 5 ist eine schematische Darstellung eines Verfahrens zum Erzeugen von Vorschlägen 300 gemäß einer Ausführungsform der vorliegenden Erfindung gezeigt. In Schritt S50 erfolgt ein Erzeugen, Ergänzen und/oder Ändern zumindest eines Teils von Plan-Daten 200 einer Immobilie 1 mithilfe eines Planungsprogramms, wobei zumindest eine Kombination von Zutrittskomponenten eines Zutrittssystems ausgewählt und/oder erzeugt wird, vorzugsweise durch einen Nutzer. Das Planungsprogramm kann auch als Software verstanden werden, mit der Gebäudepläne oder Arealpläne erstellbar sind. Ein Nutzer des Planungsprogramms kann die einzelnen Zutrittskomponenten des Zutrittssystems beispielsweise per Drag-and-Drop aus einer Bibliothek von Zutrittskomponenten auswählen und die Plan-Daten derart durch eine Kombination von Zutrittskomponenten ergänzen. Die Plan-Daten weisen somit Informationen zu dem Zutrittssystem 10 auf und geben insbesondere eine ausgewählte Kombination von Zutrittskomponenten 11, 12, 13, 14 für das geplante Zutrittssystem 10 an.

In Schritt S51 werden die Plan-Daten 200 der Immobilie 1 durch das ML-System 400 erhalten, wobei die Plan-Daten 200 die Planungsphase der Immobile 1 und/oder eines Zutrittssystems 10 der Immobilie 1 betreffen, wobei die Plan-Daten 200 die Informationen zu dem Zutrittssystem 10 aufweisen, wobei das Zutrittssystem 10 eine Kombination von Zutrittskomponenten 11, 12, 13, 14 aufweist.

In Schritt S52 erfolgt ein Analysieren der Plan-Daten 200 mithilfe des ML-Systems 400 zum Erzeugen von mindestens einem Vorschlag 300, betreffend eine oder mehrere Zutrittskomponenten 11, 12, 13, 14 des Zutrittssystems 10 der Immobilie 1, wobei der Vorschlag 300 ein Veränderungsvorschlag ist. Der Veränderungsvorschlag betrifft dabei eine oder mehrere der Zutrittskomponenten 11, 12, 13, 14 des Zutrittssystems 10. Das Analysieren in Schritt S52 umfasst vorzugsweise ein Vorhersagen von Problemen, betreffend die in den Plan-Daten 200 enthaltene Kombination von Zutrittskomponenten 11, 12, 13, 14 des mindestens einen Zutrittssystems 10, durch das ML-System 400. Die durch das ML-System 400 vorhergesagten Probleme sind dabei vorzugsweise eines, mehrere oder alle der folgenden Probleme für die spezifische, in den Plan-Daten 200 enthaltene Kombination von Zutrittskomponenten 11, 12, 13, 14:
- eine durch das ML-System 400 vorhergesagte erhöhte Abnutzung des Zutrittssystems 10 oder von einer oder mehreren der Zutrittskomponenten 11, 12, 13, 14 des Zutrittssystems 10; und/oder
- eine durch das ML-System 400 vorhergesagte erhöhte Fehleranfälligkeit des Zutrittssystems 10 oder von einer oder mehreren der Zutrittskomponenten 11, 12, 13, 14 des Zutrittssystems 10; und/oder
- ein durch das ML-System 400 vorhergesagter erhöhter Wartungsaufwand des Zutrittssystems 10 oder von einer oder mehreren der Zutrittskomponenten 11, 12, 13, 14 des Zutrittssystems 10; und/oder
- eine durch das ML-System 400 vorhergesagte verringerte Lebenszeit des Zutrittssystems 10 oder von einer oder mehreren der Zutrittskomponenten 11, 12, 13, 14 des Zutrittssystems 10; und/oder
- ein durch das ML-System 400 vorhergesagter erhöhter elektrischer Energiebedarf des Zutrittssystems 10 oder von einer oder mehreren der Zutrittskomponenten 11, 12, 13, 14 des Zutrittssystems 10.

Das ML-System 400 erzeugt vorzugsweise einen Veränderungsvorschlag, der die vorhergesagten Probleme verringert.

Es ist denkbar, dass das ML-System bei der Erzeugung des Veränderungsvorschlags eine erwartete Lieferzeit und/oder Verfügbarkeit von einzelnen Zutrittskomponenten 11, 12, 13, 14 berücksichtigt.

Der mindestens eine von dem ML-System 400 erzeugte Veränderungsvorschlag umfasst dabei einen oder mehrere der folgenden Veränderungsvorschläge:
- einen Austausch von einer oder mehreren der in den Plan-Daten 200 enthaltenen Zutrittskomponenten 11, 12, 13, 14 des Zutrittssystems 10 durch eine oder mehrere alternative Zutrittskomponenten 11, 12, 13, 14, beispielsweise ein alternatives Modell einer Zutrittskomponente;
- ein Anpassen eines Prüfungsintervalls und/oder Wartungsintervalls des Zutrittssystems 10 und/oder von einer oder mehreren Zutrittskomponenten 11, 12, 13, 14 des Zutrittssystems 10;
- ein Einstellen und/oder Anpassen von mechanischen, hydraulischen und/oder elektrischen Parametern des Zutrittssystems 10 und/oder einer oder mehrerer Zutrittskomponenten 11, 12, 13, 14 des Zutrittssystems 10.

Nach Schritt S52 erfolgt optional ein Schritt S53 und/oder optional ein Schritt S54.

In Schritt S53 erfolgt ein Ausgeben des mindestens einen Vorschlags 300 in Abhängigkeit der in Schritt S52 durchgeführten Analyse. Insbesondere wird der in Schritt S52 erzeugte mindestens eine Veränderungsvorschlag ausgegeben und derart einem Nutzer zur Verfügung gestellt. Das Ausgeben des Veränderungsvorschlags kann beispielsweise optisch über einen Computerbildschirm des Computersystems 100 erfolgen.

In Schritt S54 erfolgt ein Ergänzen und/oder Ändern der Plan-Daten 200 durch den mindestens einen Vorschlag 300 in Abhängigkeit der in Schritt S52 durchgeführten Analyse. Insbesondere ergänzt und/oder ändert das ML-System die Plan-Daten 200 dabei automatisiert entsprechend des in Schritt S52 erzeugten Vorschlags 300.

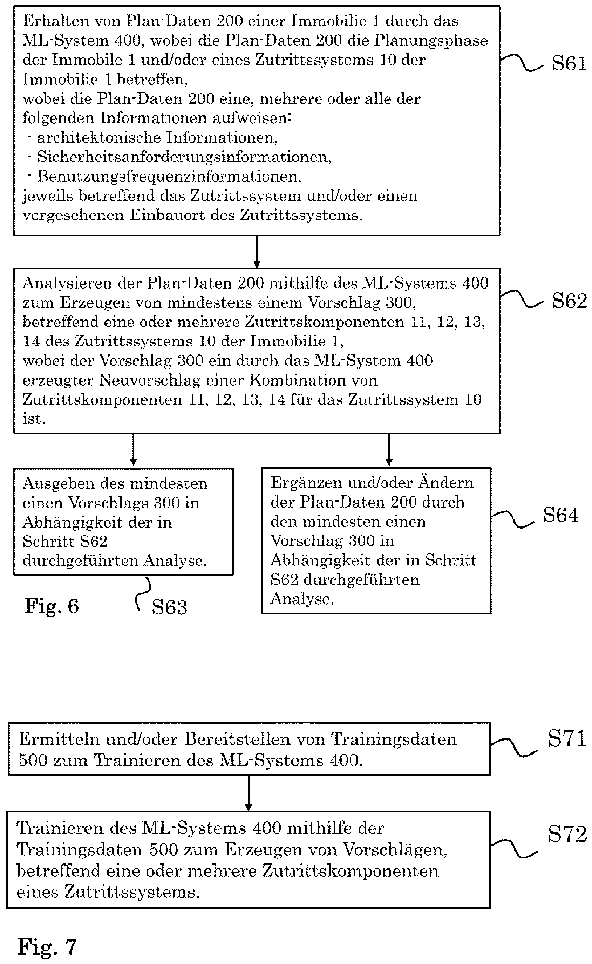

In Fig. 6 ist eine schematische Darstellung eines Verfahrens zum Erzeugen von Vorschlägen 300 gemäß einer Ausführungsform der vorliegenden Erfindung gezeigt. In Schritt S61 erfolgt ein Erhalten von Plan-Daten 200 einer Immobilie 1 durch das ML-System 400, wobei die Plan-Daten 200 die Planungsphase der Immobile 1 und/oder eines Zutrittssystems 10 der Immobilie 1 betreffen,
wobei die Plan-Daten 200 eine, mehrere oder alle der folgenden Informationen aufweisen:
- architektonische Informationen,
- Sicherheitsanforderungsinformationen,
- Benutzungsfrequenzinformationen,
jeweils betreffend das Zutrittssystem 10 und/oder einen vorgesehenen Einbauort des Zutrittssystems 10.

In Schritt S62 erfolgt ein Analysieren der Plan-Daten 200 mithilfe des ML-Systems 400 zum Erzeugen von mindestens einem Vorschlag 300, betreffend eine oder mehrere Zutrittskomponenten 11, 12, 13, 14 des Zutrittssystems 10 der Immobilie 1, wobei der Vorschlag 300 ein durch das ML-System 400 erzeugter Neuvorschlag einer Kombination von Zutrittskomponenten 11, 12, 13, 14 für das Zutrittssystem 10 ist. Es ist daher denkbar, dass die in Schritt S61 erhaltenen Plan-Daten noch keine Auswahl von speziellen Zutrittskomponenten umfassen, sondern dass das ML-System 400 in Schritt S62 einen eigenständigen Neuvorschlag einer bestimmten Kombination von Zutrittskomponenten 11, 12, 13, 14 erzeugt. Das ML-System 400 erzeugt den Neuvorschlag dabei unter Berücksichtigung der in den Plan-Daten 200 vorhandenen architektonischen Informationen, Sicherheitsanforderungsinformationen, und/oder Benutzungsfrequenzinformationen.

Nach Schritt S62 erfolgt optional ein Schritt S63 und/oder optional ein Schritt S64.

In Schritt S63 erfolgt ein Ausgeben des mindestens einen Vorschlags 300 in Abhängigkeit der in Schritt S62 durchgeführten Analyse. Insbesondere wird der in Schritt S62 erzeugte Neuvorschlag ausgegeben und derart einem Nutzer zur Verfügung gestellt. Das Ausgeben des Neuvorschlags kann beispielsweise optisch über einen Computerbildschirm des Computersystems 100 erfolgen.

In Schritt S64 erfolgt ein Ergänzen und/oder Ändern der Plan-Daten 200 durch den mindestens einen Vorschlag 300 in Abhängigkeit der in Schritt S62 durchgeführten Analyse. Insbesondere ergänzt und/oder ändert das ML-System 400 die Plan-Daten 200 dabei automatisiert entsprechend des in Schritt S62 erzeugten Vorschlags 300.

In Fig. 7 ist eine schematische Darstellung eines Verfahrens zum Trainieren eines ML-Systems 400 gemäß einer Ausführungsform der vorliegenden Erfindung gezeigt. In einem Schritt S71 erfolgt ein Ermitteln und/oder Bereitstellen von Trainingsdaten 500 zum Trainieren des ML-Systems 400. Die Trainingsdaten 500 kommen dabei vorzugsweise aus der Anwendung realer Zutrittssysteme und werden beispielsweise aus der alltäglichen Wartung und/oder Reparatur von Zutrittssystemen erhalten. In einem Schritt S72 erfolgt ein Trainieren des ML-Systems 400 mithilfe der Trainingsdaten 500 zum Erzeugen von Vorschlägen, betreffend eine oder mehrere Zutrittskomponenten eines Zutrittssystems. Das derart trainierte ML-System 400 kann beispielsweise in einem Verfahren gemäß der Fig. 4, Fig. 5 oder der Fig. 6 verwendet werden.

Merkmale der in den Figuren 3A, 3B, 4, 5, 6 und 7 dargestellten Ausführungsbeispiele können untereinander kombiniert werden.

### Bezugszeichenliste

- 1: Immobilie
- 10: Zutrittssystem
- 10': weiteres Zutrittssystem
- 11, 12, 13, 14: Zutrittskomponenten
- 100: Computersystem
- 200: Plan-Daten
- 300: Vorschlag
- 400: ML-System
- 500: Trainingsdaten
- S41 - S43: Schritte
- S50 - S54: Schritte
- S61 - S64: Schritte
- S71 - S72: Schritte

## Patentansprüche

1. Verfahren zum Erzeugen von Vorschlägen (300), betreffend eine oder mehrere Zutrittskomponenten (11, 12, 13, 14) eines Zutrittssystems (10), mithilfe eines ML-Systems (400),
wobei das Verfahren zum Erzeugen von Vorschlägen (300) umfasst:
--- a1) Erhalten von Plan-Daten (200) einer Immobilie (1) durch das ML-System (400), wobei die Plan-Daten (200) die Planungsphase der Immobile (1) und/oder eines Zutrittssystems (10) der Immobilie (1) betreffen,
--- a2) Analysieren der Plan-Daten (200) mithilfe des ML-Systems (400) zum Erzeugen von mindestens einem Vorschlag (300), betreffend eine oder mehrere Zutrittskomponenten (11, 12, 13, 14) des Zutrittssystems (10) der Immobilie (1).

2. Verfahren nach Anspruch 1, wobei die in Schritt a1) durch das ML-System (400) erhaltenen Plan-Daten (200) Informationen zu dem Zutrittssystem (10) aufweisen, wobei das Zutrittssystem (10) eine Kombination von Zutrittskomponenten (11, 12, 13, 14) aufweist, wobei der in Schritt a2) erzeugte Vorschlag (300) ein Veränderungsvorschlag, betreffend eine oder mehrere der Zutrittskomponenten (11, 12, 13, 14) des Zutrittssystems (10), ist.

3. Verfahren nach Anspruch 2, wobei der Veränderungsvorschlag einen oder mehrere der folgenden Veränderungsvorschläge betrifft:
- einen Austausch von einer oder mehreren Zutrittskomponenten (11, 12, 13, 14) des Zutrittssystems (10);
- ein Anpassen eines Prüfungsintervalls und/oder Wartungsintervalls des Zutrittssystems (10) und/oder von einer oder mehreren Zutrittskomponenten (11, 12, 13, 14) des Zutrittssystems (10);
- ein Einstellen und/oder Anpassen von mechanischen, hydraulischen und/oder elektrischen Parametern des Zutrittssystems (10) und/oder von einer oder mehreren Zutrittskomponenten (11, 12, 13, 14) des Zutrittssystems (10).

4. Verfahren nach einem der vorhergehenden Ansprüche, wobei das Verfahren ferner umfasst:
--- a0) Erzeugen, Ergänzen und/oder Ändern zumindest eines Teils der Plan-Daten (200) mithilfe eines Planungsprogramms, wobei zumindest die Kombination von Zutrittskomponenten (11, 12, 13, 14) des Zutrittssystems (10) ausgewählt und/oder erzeugt wird, insbesondere durch einen Nutzer des Planungsprogramms.

5. Verfahren nach einem der vorhergehenden Ansprüche, wobei die in Schritt a1) durch das ML-System (400) erhaltenen Plan-Daten (200) eine, mehrere oder alle der folgenden Informationen aufweisen:
- architektonische Informationen, insbesondere bezüglich eines vorhandenen Bauraums für das Zutrittssystem (10) oder für Zutrittskomponenten (11, 12, 13, 14) des Zutrittssystems (10); und/oder
- Sicherheitsanforderungsinformationen, betreffend Sicherheitsanforderungen an das Zutrittssystem (10) oder an Zutrittskomponenten (11, 12, 13, 14) des Zutrittssystems (10); und/oder
- Benutzungsfrequenzinformationen, betreffend eine erwartete Benutzungsfrequenz des Zutrittssystems (10) oder von Zutrittskomponenten (11, 12, 13, 14) des Zutrittssystems (10).

6. Verfahren nach Anspruch 5, wobei der Vorschlag (300) in Schritt a2) ein durch das ML-System (400) erzeugter Neuvorschlag einer Kombination von Zutrittskomponenten (11, 12, 13, 14) für ein Zutrittssystem (10) ist, wobei der Neuvorschlag durch das ML-System (400) zumindest in Abhängigkeit der in den Plan-Daten (200) vorhandenen architektonische Informationen, Sicherheitsanforderungsinformationen und/oder Benutzungsfrequenzinformationen erzeugt wird.

7. Verfahren nach einem der vorhergehenden Ansprüche, wobei das ML-System (400) in Schritt a2) den mindestens einen Vorschlag (300), insbesondere den Veränderungsvorschlag oder Neuvorschlag, unter Berücksichtigung eines, mehrerer oder aller der folgenden Eigenschaften und/oder Parameter erzeugt:
- eine von dem ML-System (400) erwartete Abnutzung des Zutrittssystems (10) oder einer oder mehrerer Zutrittskomponenten (11, 12, 13, 14) des Zutrittssystems (10); und/oder
- ein von dem ML-System (400) erwarteter Wartungsaufwands des Zutrittssystems (10) oder einer oder mehrerer Zutrittskomponenten (11, 12, 13, 14) des Zutrittssystems (10); und/oder
- eine von dem ML-System (400) erwartete Lebensdauer des Zutrittssystems (10) oder einer oder mehrerer Zutrittskomponenten (11, 12, 13, 14) des Zutrittssystems (10); und/oder
- eine von dem ML-System (400) erwartete Fehleranfälligkeit des Zutrittssystems (10) oder einer oder mehrerer Zutrittskomponenten (11, 12, 13, 14) des Zutrittssystems (10); und/oder
- ein von dem ML-System (400) erwarteter elektrischer Energiebedarf des Zutrittssystems (10) oder einer oder mehrerer Zutrittskomponenten (11, 12, 13, 14) des Zutrittssystems (10),
vorzugsweise jeweils bezüglich einer bestimmten Kombination von Zutrittskomponenten (11, 12, 13, 14).

8. Verfahren nach einem der vorhergehenden Ansprüche, wobei das ML-System (400) in Schritt a2) den mindestens einen Vorschlag (300), insbesondere den Veränderungsvorschlag oder Neuvorschlag, unter Berücksichtigung einer erwarteten Lieferzeit von Zutrittskomponenten (11, 12, 13, 14) und/oder einer Verfügbarkeit von Zutrittskomponenten (11, 12, 13, 14) erzeugt.

9. Verfahren nach einem der vorhergehenden Ansprüche, wobei das ML-System (400) in Schritt a2) den mindestens einen Vorschlag (300) zur Angleichung und/oder Abstimmung der erwarteten Wartungsintervalle der einzelnen Türkomponenten (11, 12, 13, 14) des Türsystems (10) erzeugt.

10. Verfahren zum Trainieren eines ML-Systems (400), insbesondere zur Verwendung des trainierten ML-Systems (400) in einem Verfahren gemäß einem der vorhergehenden Ansprüche,
wobei das Verfahren zum Trainieren des ML-Systems (400) die folgenden Schritte umfasst:
--- b1) Ermitteln und/oder Bereitstellen von Trainingsdaten (500) zum Trainieren des ML-Systems (400),
--- b2) Trainieren des ML-Systems (400) mithilfe der Trainingsdaten (500) zum Erzeugen von Vorschlägen (300), betreffend eine oder mehrere Zutrittskomponenten (11, 12, 13, 14) eines Zutrittssystems (10).

11. Verfahren nach Anspruch 10, wobei das ML-System (400) in Schritt b2) zur Erkennung und/oder Vorhersage von Problemen, betreffend Kombinationen von Zutrittskomponenten (11, 12, 13, 14) von Zutrittssystemen (10), trainiert wird.

12. Verfahren nach einem der Ansprüche 10 oder 11, wobei die Trainingsdaten (500):
- Zutrittskomponenteninformationen, betreffend die in Kombination verwendeten Zutrittskomponenten (11, 12, 13, 14) von Zutrittssystemen (10); und
- Labelinformationen, betreffend in der Anwendung der in Kombination verwendeten Zutrittskomponenten (11, 12, 13, 14) ermittelte Fehler, Probleme, Abnutzungserscheinungen, und/oder Eigenschaften
umfassen,
wobei in Schritt b2) mithilfe der Zutrittskomponenteninformationen und Labelinformationen ein überwachtes Lernen zum Training des ML-Systems (400) durchgeführt wird.

13. Computersystem (100), aufweisend ein ML-System (400), wobei das Computersystem (100) zum Ausführen eines Verfahrens nach einem der vorhergehenden Ansprüche konfiguriert ist.

14. Trainingsdaten (500) zur Verwendung in einem Verfahren nach einem der Ansprüche 10 bis 13,
wobei die Trainingsdaten (500):
- Kombinationen von Zutrittskomponenten (11, 12, 13, 14) von Zutrittssystemen (10) und
- in der Anwendung der Kombinationen von Zutrittskomponenten (11, 12, 13, 14 ermittelte Fehler, Abnutzungserscheinungen, Probleme und/oder Eigenschaften
betreffen.

15. Computerprogrammprodukt, umfassend Befehle, die bei der Ausführung durch ein Computersystem, dieses veranlassen, ein Verfahren nach einem der Ansprüche 1 bis 12 durchzuführen.
